# EUROPEAN PATENT APPLICATION

(11) **EP 4 636 139 A1**
(43) Date of publication of application: **22.10.2025**
(21) Application number: 23903311.1
(22) Date of filing: 01.12.2023
(51) Int. Cl.: C30B 29/36, C30B 29/04, C30B 29/06, C30B 29/16, C30B 29/38, C30B 33/06, H01L 21/02, H01L 21/322

(54) **SEMICONDUCTOR SUBSTRATE AND METHOD FOR PRODUCING SEMICONDUCTOR SUBSTRATE**

(30) Priority: 16.12.2022 JP 2022201358
(71) Applicant: SUMITOMO METAL MINING CO., LTD., Tokyo 105-8716 (JP)
(72) Inventor: UCHIDA, Hidetsugu, Tokyo 105-0004 (JP); KOBAYASHI, Motoki, Tokyo 105-0004 (JP)
(74) Representative: TBK
(86) International application number: PCT/JP2023/043033
(87) International publication number: WO 2024/128021

(57) **Abstract**

Provided is a semiconductor substrate and a method for producing the semiconductor substrate that are resistant to metal contamination by gettering metals that cause metal contamination.

A semiconductor substrate comprising a first semiconductor layer and a second semiconductor layer in contact with the first semiconductor layer, wherein at least one of the first semiconductor layer and the second semiconductor layer has a sessile dislocation composed of a stacking fault and a dislocation loop surrounding the stacking fault, and the density of the sessile dislocation is 1E13/cm³ to 1E18/cm³.

## Description

### Technical field

The present invention relates to a semiconductor substrate and a method for manufacturing a semiconductor substrate capable of gettering metals that cause metal contamination.

### Background Art

A technology for bonding a SiC single crystal and a SiC polycrystal is known as a technology for forming a semiconductor bonded substrate. As a related technique, for example, the technique disclosed in Patent Literature 1 is known.

### Citation List

### Patent Literature

Patent Literature 1: JP 6206786 B

### Summary of the invention

### Problem to be solved by the invention

Metal contamination in a semiconductor device is known to reduce the manufacturing yield or reliability of the device by lowering the withstand voltage of the gate insulating film or generating leakage current. Even in the case of a semiconductor bonded substrate, it is desirable for the semiconductor bonded substrate to be resistant to the metal contamination, since a semiconductor element or a semiconductor device are formed on the bonded substrate.

Therefore, the present invention aims to provide a semiconductor substrate and a method for producing the semiconductor substrate that are resistant to the metal contamination by gettering metals that cause the metal contamination.

### Solution to Problem

In order to solve the above-described problem, the semiconductor substrate of the present invention is a semiconductor substrate comprising a first semiconductor layer and a second semiconductor layer in contact with the first semiconductor layer, wherein at least one of the first semiconductor layer and the second semiconductor layer has a sessile dislocation composed of a stacking fault and a dislocation loop surrounding the stacking fault, and the density of the sessile dislocation is 1E13/cm³ to 1E18/cm³.

The first semiconductor layer and the second semiconductor layer may be any of silicon carbide (SiC), silicon (Si), carbon (C), gallium nitride (GaN), aluminum nitride (AIN), and gallium oxide (Ga₂O₃).

The first semiconductor layer may be a silicon carbide single crystal layer in which the sessile dislocation is present, and the second semiconductor layer may be a silicon carbide polycrystalline layer.

The semiconductor substrate of the present invention may further comprise an epitaxial layer in contact with the first semiconductor layer.

The semiconductor substrate of the present invention may further comprise at least one of a semiconductor element and a semiconductor device in contact with the epitaxial layer.

In order to solve the above problem, the method for manufacturing a semiconductor substrate of the present invention comprises an introduction step of introducing a vacancy and an interstitial atom into at least one of a first semiconductor layer and a second semiconductor layer in contact with the first semiconductor layer of the semiconductor substrate, and a heat treatment step of heat-treating the semiconductor substrate after the introduction step to form a sessile dislocation having a density of 1E13/cm³ to 1E18/cm³ in the layer into which the vacancy and the interstitial atom have been introduced.

The introduction step may be a step of introducing the vacancy and the interstitial atom by at least one of ion implantation, neutral element implantation, plasma irradiation, and sputtering.

### Effects of the Invention

The presence of sessile dislocation with a density of 1E13/cm³ to 1E18/cm³ allows the sessile dislocation to getter metals, making the semiconductor substrate of the present invention resistant to metal contamination. Therefore, by forming a semiconductor element or semiconductor device on the semiconductor substrate of the present invention, even if metal contamination occurs, the metal is gettered by the sessile dislocation, so that it is possible to suppress a decrease in device yield and reliability due to poor voltage resistance of the gate insulating film or the generation of leakage current.

### Brief Description of the Drawings

[Figure 1] A schematic cross-sectional view of a bonded SiC substrate, which is an example of a semiconductor substrate.
[Figure 2] A TEM observation image of a cross-section of a single-crystal SiC layer in the region of the bonded SiC substrate shown in Figure 1, where a sessile dislocation formed in the single-crystal SiC layer is observed.
[Figure 3A] A TEM observation image of an enlarged region in the region shown in Fig. 2 where the sessile dislocation is observed.
[Figure 3B] Schematic diagram of the sessile dislocation which was observed.
[Figure 4] A horizontally connected image of TEM observation images of the single crystal SiC layer of the bonded SiC substrate when the density of the sessile dislocation is about 5E14/cm³.
[Figure 5] A horizontally connected image of TEM observation images of the single crystal SiC layer of the bonded SiC substrate when the density of the sessile dislocation is about 8E14/cm³.
[Figure 6] A cross-sectional TEM observation image of the single crystal layer after a heat treatment step at 1100°C in a bonded substrate in which a support substrate is polycrystalline SiC and a single crystal layer is a single crystal layer of 4H-SiC.
[Figure 7] A cross-sectional TEM observation image of the single crystal layer after a heat treatment step at 1700°C in a bonded substrate in which a support substrate is polycrystalline SiC and a single crystal layer is a single crystal layer of 4H-SiC.
[Figure 8] A flow diagram showing an example of a method for manufacturing a semiconductor substrate of the present invention.
[Figure 9] A perspective view of a bonded substrate, which is an example of a semiconductor substrate of the present invention.
[Figure 10] A schematic side view of a semiconductor substrate of the present invention.
[Figure 11] A schematic side view of a semiconductor substrate of the present invention.
[Figure 12] An explanatory diagram showing an example of an irradiation step, which is one of the manufacturing steps of a semiconductor substrate.
[Figure 13] A schematic side view of a bonded substrate in a manufacturing process of a semiconductor substrate.
[Figure 14] A schematic side view of a bonded substrate in a manufacturing process of a semiconductor substrate.
[Figure 15] A schematic side view of a bonded substrate in a manufacturing process of a semiconductor substrate.
[Figure 16A] A schematic cross-sectional view of a substrate in which a SiC epitaxial layer is grown on a single crystal SiC layer of a bonded substrate, as a substrate of an example used in SIMS analysis.
[Figure 16B] A result of SIMS analysis of the substrate.
[Figure 17A] A schematic cross-sectional view of a substrate in which a SiC epitaxial layer is grown on a single crystal SiC substrate, as a substrate of a reference example used in SIMS analysis.
[Figure 17B] A result of SIMS analysis of the substrate.

### Detailed Description of Embodiments

An example of an embodiment of the present invention will be described below with reference to the drawings.

### [Semiconductor substrate]

The semiconductor substrate includes a first semiconductor layer and a second semiconductor layer in contact with the first semiconductor layer. An example of the semiconductor substrate is a bonded substrate in which the first semiconductor layer and the second semiconductor layer are bonded via a bonding interface.

### <Configuration of bonded substrate 10>

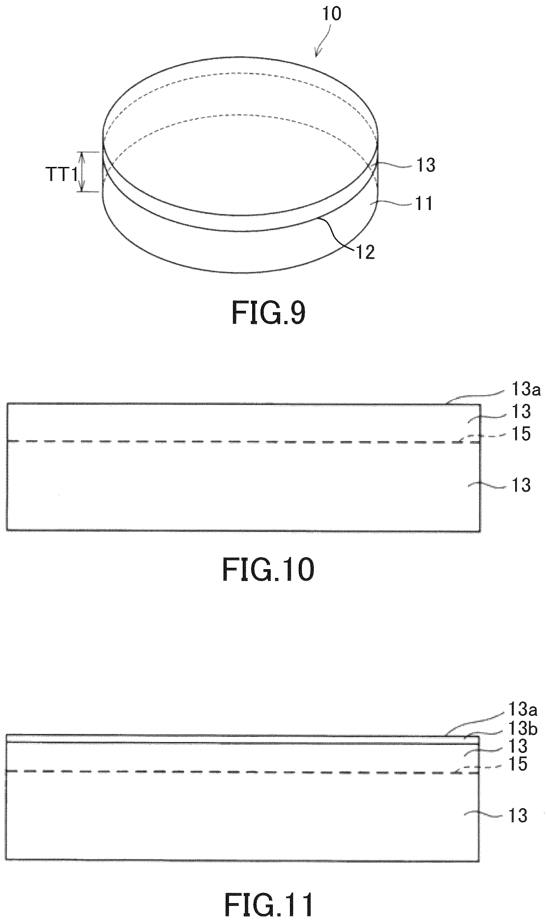

Figure 9 shows a perspective view of a bonded substrate 10 as an example of the semiconductor substrate of the present invention. For example, the bonded substrate 10 is formed in a substantially disk shape with an orientation flat. The bonded substrate 10 includes a support substrate 11 arranged on the lower side, which is an example of the second semiconductor layer, and a single crystal layer 13, which is an example of the first semiconductor layer bonded to the upper surface of the support substrate 11. The single crystal layer 13 is bonded to the support substrate 11 via a bonding interface 12.

The single crystal layer 13 may be, for example, any of compound semiconductors (e.g., silicon carbide (SiC), gallium nitride (GaN), aluminum nitride (AIN), gallium oxide (Ga₂O₃) or single element semiconductors (e.g., silicon (Si), carbon (C)). These elements are semiconductor materials that can be used in the fabrication of semiconductor devices.

Various materials can be used for the support substrate 11. It is preferable that the support substrate 11 has resistance to various thermal processes applied to the single crystal layer 13. In addition, the support substrate 11 is preferably made of a material whose thermal expansion coefficient differs little from that of the single crystal layer 13. For example, the support substrate 11 can be made of any of silicon carbide (SiC), silicon (Si), carbon (C), gallium nitride (GaN), aluminum nitride (AIN), gallium oxide (Ga₂O₃), sapphire (Al₂O₃), and quartz (SiO₂).

When polycrystalline SiC is used for the support substrate 11, SiC crystals of various polytypes and surface orientations may be mixed. Polycrystalline SiC with a mixture of various polytypes and surface orientations can be manufactured without strict temperature control, so that this makes it possible to reduce the cost of manufacturing the support substrate 11.

The thickness TT1 of the support substrate 11 may be determined so as to obtain a mechanical strength capable of withstanding the formation of an epitaxial layer and subsequent processing steps, such as the formation of a semiconductor element or a semiconductor device thereon. For example, the thickness TT1 may be approximately 350 (µm) when the diameter of the support substrate 11 is 150 (mm).

### <Explanation of sessile dislocation>

In the semiconductor substrate of the present invention, at least one of the first semiconductor layer and the second semiconductor layer has a sessile dislocation composed of a stacking fault and a dislocation loop surrounding the stacking fault. In the following, the sessile dislocation is described in the case where the first semiconductor layer is a single crystal SiC layer, which is an example of the single crystal layer 13, the second semiconductor layer is a polycrystalline SiC substrate, which is an example of the support substrate 11, and the sessile dislocation is present in the single crystal SiC layer.

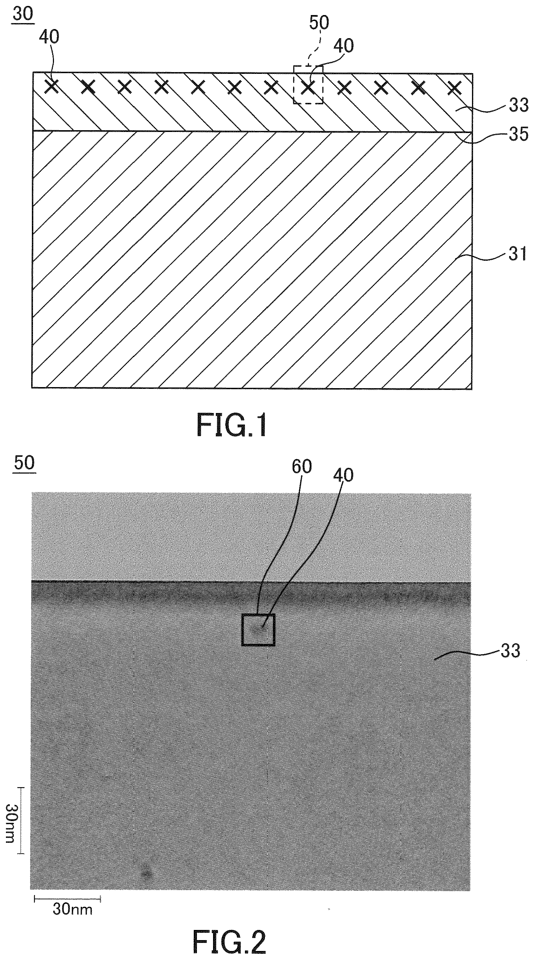

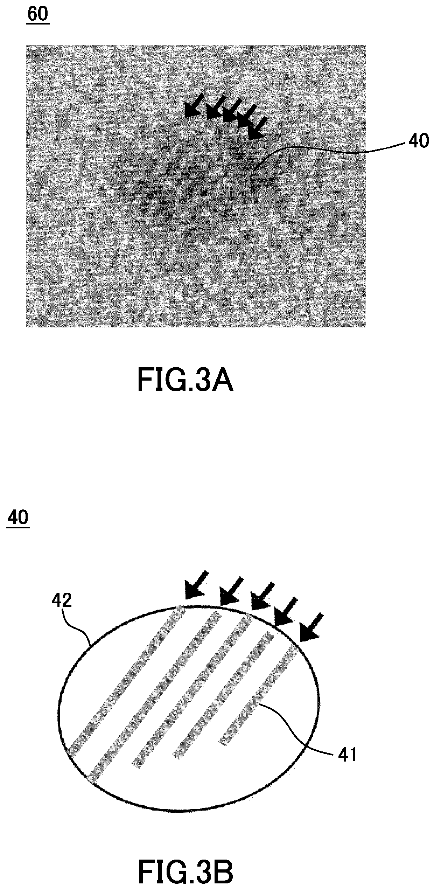

Fig. 1 shows a schematic cross-sectional view of a bonded SiC substrate 30, which is an example of a semiconductor substrate. Fig. 2 shows a TEM observation image of a cross-section of the single crystal SiC layer 33 in a region 50 of the bonded SiC substrate 30 shown in Fig. 1, where a sessile dislocation 40 formed in the single crystal SiC layer 33 is observed. Fig. 3A shows a TEM observation image of an enlarged region 60 in the region 50 shown in Fig. 2 where the sessile dislocation 40 is observed. Fig. 3B shows a schematic diagram of the sessile dislocation 40 which was observed. In FIG. 1, the bonded SiC substrate 30 has a single crystal SiC layer 33 disposed on a polycrystalline SiC substrate 31, and the sessile dislocation 40 is indicated by "x" in the single crystal SiC layer 33. Also, the bonded SiC substrate 30 has a bonded interface 35 formed by bonding the polycrystalline SiC substrate 31 and the single crystal SiC layer 33.

FIG. 2 is a TEM observation image of a cross section of the region 50 including the sessile dislocation 40 indicated by "x" in FIG. 1, and the presence of the sessile dislocation 40 observed as a circular dark region near the center of the single crystal SiC layer 33 is recognized. The photograph shown in FIG. 3A is a TEM observation image of an enlarged region 60 including the sessile dislocation 40 in FIG. 2, and FIG. 3B shows a schematic diagram of the sessile dislocation 40 observed in FIG. 3A. As indicated by multiple arrows in the region of the sessile dislocation 40 in FIG. 3A, moiré fringes resulting from differences in the periodicity of the atomic arrangement are confirmed as multiple oblique lines. When the sessile dislocation 40 observed in FIG. 3A is shown diagrammatically in FIG. 3B, the sessile dislocation 40 is composed of a stacking fault 41 seen as the moiré fringe and a dislocation loop 42 surrounding the stacking fault 41 (FIG. 3B). From the observed the sessile dislocation 40, no crystal defects such as dislocations extend from the sessile dislocation 40 to the outside of the sessile dislocation 40. Therefore, although the sessile dislocation 40 exists in the single crystal SiC layer 33, it does not adversely affect the epitaxial layer, the semiconductor element, or the semiconductor device formed on the single crystal SiC layer 33.

That is, the sessile dislocation 40 is a defect composed of the stacking fault 41 and the dislocation loop 42 around it, and this type of defect acts as a metal getter, and since new crystal defects do not extend from the sessile dislocation 40 to the outside of the dislocation loop, the crystal defects do not reach the epitaxial layer, the semiconductor element, or the semiconductor device formed on the bonded substrate 10, and there is no adverse effect on the epitaxial layer, the semiconductor element, or the semiconductor device.

The density of the sessile dislocation 40 having metal gettering ability is within the range of 1E13/cm³ to 1E18/cm³. If there are few sessile dislocations 40, the metal gettering ability decreases, and if there are many sessile dislocations 40, they act as trap levels, and there is a risk that carriers are captured by the trap levels, lowering the carrier concentration and increasing the resistance of the bonded substrate 10 of the semiconductor. If the density of the sessile dislocation 40 is within the above range, the metal gettering ability is satisfied and the resistance of the bonded substrate 10 is not increased.

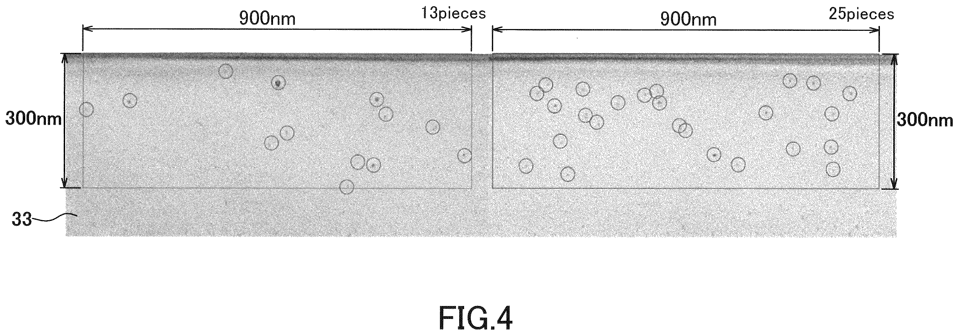

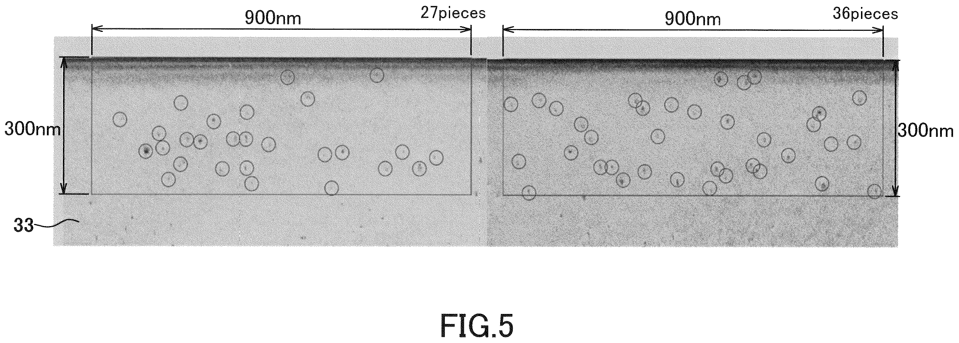

As an example of calculating the density of the sessile dislocation 40 in the single crystal SiC layer 33, TEM observation images of the single crystal SiC layer 33 of the bonded SiC substrate 30 connected horizontally is indicated in Figs. 4 and 5. The number of the sessile dislocations formed in the single crystal SiC layer was counted from the TEM image of a TEM sample having a thickness of 150 nm, and the density was calculated. As a result, the density of the sessile dislocation 40 was about 5E14/cm³ in the case of Fig. 4 and about 8E14/cm³ in the case of Fig. 5. Note that the thickness of the TEM sample in the direction perpendicular to the paper surface on which the TEM observation image is shown in Figs. 4 and 5 is 150 nm. That is, the number of the sessile dislocations 40 present in the square frame on the left side shown in Fig. 4 is 13, but the volume of the TEM sample is 81,000,000 nm³ (volume of the sample obtained from 150 nm x 300 nm x 900 nm), which indicates that there are 13 sessile dislocations in this volume. The volume in the square frame on the right side shown in FIG. 4 is the same as the volume in the square frame on the left side, and the number of the sessile dislocations 40 present in the right frame is 25. From the total number of the sessile dislocations in these two square frames in FIG. 4 (38) and the volume of the TEM sample (81000000 nm³×2), the sessile dislocation density in the single crystal SiC layer 33 is calculated to be 4.75E14/cm³. For FIG. 5, the same calculation procedure as for FIG. 4 is performed, from the total number (63) of the sessile dislocations in these two square frames and the volume of the TEM sample (81000000 nm³×2), the sessile dislocation density in the single crystal SiC layer 33 is calculated to be 7.77E14/cm³.

The sessile dislocation 40 may be present in only one of the first semiconductor layer and the second semiconductor layer, or may be present in both. No matter which layers the sessile dislocation 40 is present, the sessile dislocation can act as metal gettering. When the sessile dislocation 40 exist only in the first semiconductor layer, the density of the sessile dislocation 40 can be calculated from the number of sessile dislocations 40 in the first semiconductor layer and the volume of the first semiconductor layer by the same calculation procedure as above. Also, when the sessile dislocation 40 exist only in the second semiconductor layer, the density of the sessile dislocation 40 can be calculated from the number of sessile dislocations 40 in the second semiconductor layer and the volume of the second semiconductor layer by the same calculation procedure as above. When the sessile dislocation 40 exist in both the first semiconductor layer and the second semiconductor layer, the density of the sessile dislocation 40 can be calculated from the number of sessile dislocations 40 in the first semiconductor layer and the second semiconductor layer and the sum of the volumes of the first semiconductor layer and the second semiconductor layer by the same calculation procedure as above.

For example, in the case of the bonded substrate 10, it is preferable that the single crystal layer 13 is a silicon carbide single crystal layer (single crystal SiC layer 33) in which the sessile dislocation 40 exist, and the support substrate 11 is a silicon carbide polycrystalline layer (polycrystalline SiC substrate 31). Assuming that an epitaxial layer is formed on the single crystal layer 13, and that a semiconductor element or a semiconductor device is further formed on top of that, metal contamination can be more effectively prevented by having sessile dislocations 40 exist in the single crystal layer 13, which is closer to the epitaxial layer, semiconductor element or semiconductor device, where metal contamination is to be prevented, than in the support substrate 11. That is, even if the sessile dislocation 40 exist only in the support substrate 11, the sessile dislocation 40 can get metal, but if the sessile dislocation 40 exists only in the single crystal layer 13, or in both the single crystal layer 13 and the support substrate 11, the sessile dislocation 40 is more likely to gettering metal.

The same applies when a semiconductor substrate is made of a material other than silicon carbide, the sessile dislocation 40 is present only in the single crystal layer or in both the single crystal layer and the support substrate, and the sessile dislocation 40 is more likely to gettering metal.

The semiconductor substrate of the present invention may further comprise an epitaxial layer in contact with the first semiconductor layer. Specifically, the epitaxial layer may be provided on the single crystal layer in which the sessile dislocation 40 of the bonded substrate is present.

The semiconductor substrate of the present invention may further comprise at least one of the semiconductor element and the semiconductor device in contact with the first semiconductor layer or the epitaxial layer.

### [Method of Manufacturing a Semiconductor Substrate]

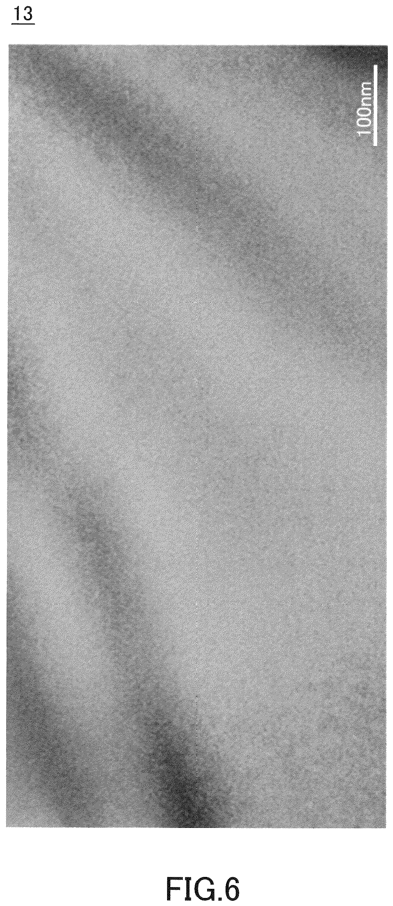

As an example of a method of manufacturing a semiconductor substrate having a first semiconductor layer and a second semiconductor layer, a method of manufacturing the bonded substrate 10 will be described with reference to Figs. 6 to 14. Specifically, the case where the support substrate 11 is polycrystalline SiC, the single crystal layer 13 is a single crystal layer of 4H-SiC, and a delamination technique using hydrogen atom ablation is used to manufacture a semiconductor substrate will be described.

First, the support substrate 11 and the single crystal layer 13 are prepared. The surfaces of the support substrate 11 and the single crystal layer 13 can be obtained in a state where these bonding target surfaces are already planarized. The bonding target surfaces may be planarized by grinding or cutting, or using a CMP method.

### <Hydrogen ion implantation step (step S0)>

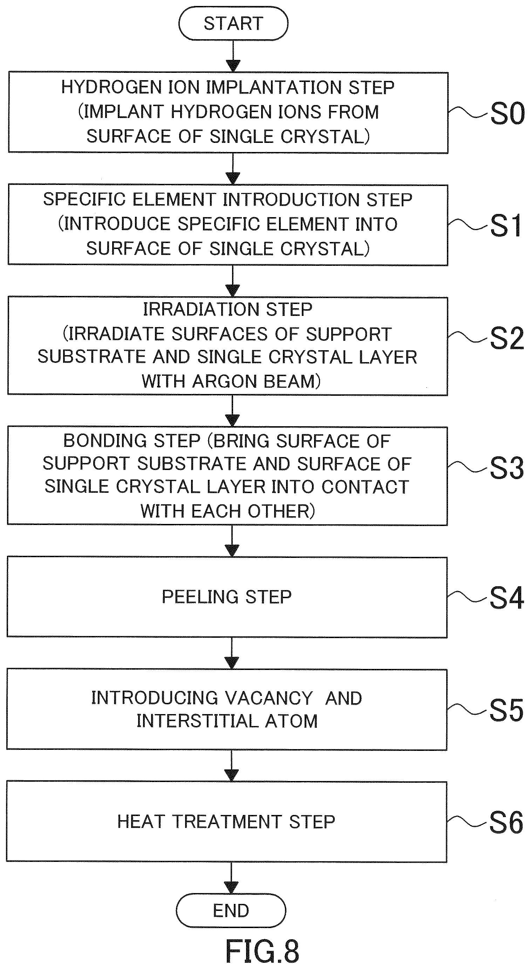

In step S0 of FIG. 8, a hydrogen ion implantation step is performed in which hydrogen ion is implanted from the bonding target surface 13a of the single crystal layer 13. When the hydrogen ion is implanted into the single crystal layer 13, the hydrogen ion reachs a depth corresponding to the incident energy and is distributed at a high concentration. As a result, a hydrogen implantation layer 15 shown by a dotted line is formed at a predetermined depth from the bonding target surface 13a, as shown in the side schematic diagram of FIG. 10. For example, the hydrogen implantation layer 15 is formed at a depth of about 0.5 µm from the bonding target surface 13a.

### <Specific element introduction step (step S1)>

This step is a step of introducing a specific element into the bonding target surface 13a of the single crystal layer 13 or the bonding target surface 11a of the support substrate 11. The specific element may be introduced into both the bonding target surface 11a and the bonding target surface 13a.

In FIG. 8, in step S1, the specific element introduction step is performed. In the case where the substrate is SiC, the specific element is preferably an atom that can bond with Si or C. In this embodiment, the case where phosphorus (P) is used as the specific element will be described below. Phosphorus (P) is introduced from the bonding target surface 13a of the single crystal layer 13 by using ion implantation. As a result, a doping layer 13b is formed on the surface of the single crystal layer 13, as shown in the schematic side view of FIG. 11.

When the first and second semiconductor substrates are N-type semiconductors, a pentavalent element can be used as the specific element, and when the first and second semiconductor substrates are P-type semiconductors, a trivalent element can be used as the specific element.

### <Irradiation step (step S2)>

This step is a step of irradiating the bonding target surface 11a or the bonding target surface 13a with an argon beam after the specific element introduction step and before the bonding step. Both the bonding target surface 11a and the bonding target surface 13a may be irradiated with an argon beam.

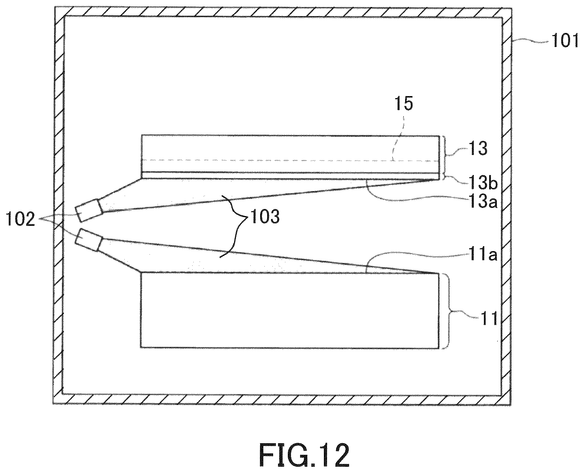

In FIG. 8, the irradiation step is performed in step S2. First, the single crystal layer 13 and the support substrate 11 are set in the chamber 101 so as to be arranged as shown in FIG. 12, and then the relative positions of the single crystal layer 13 and the support substrate 11 are aligned. The alignment is performed so that the two substrates can come into contact with each other in the correct positional relationship in the bonding step described later. Next, the chamber 101 is evacuated. The degree of vacuum in the chamber 101 may be, for example, about 1 ×10⁻⁴ to 1 ×10⁻⁶ Pa.

Next, a neutral element beam 103 of argon (Ar) is irradiated to the bonding target surface 11a of the support substrate 11 and the bonding target surface 13a of the single crystal layer 13 using a fast atomic beam gun (FAB gun) 102. The neutral element beam of argon (Ar) is uniformly irradiated to the entire surface of the bonding target surface 11a and the entire surface of the bonding target surface 13a. This removes the oxide film and adsorption layer on the bonding target surface 11a and the bonding target surface 13a to expose the bonds. This state is called an active state. In addition, since the irradiation step is a step in a vacuum, the bonding target surface 11a and the bonding target surface 13a can maintain an active state without being oxidized, etc.

Note that the irradiation step is not an essential step, and can be omitted if the bonding substrate can be formed without problems by bonding two substrates by the bonding step described later. The irradiation step is a step in which atoms or molecules are collided with the surface to remove oxides and adsorption layers on the surface by the sputtering phenomenon, but instead of this step, a step in which a reactive gas is used to chemically react with the contaminants on the surface and remove them by etching can be considered. Also, if the adsorption material is easily sublimated, it is possible to remove the adsorption material by simply applying heat or light through sublimation. By using these steps instead of the irradiation step, it is possible to remove the oxide film and adsorption layers on the bonding target surface to expose the bonds.

### <Bonding step (step S3)>

This step is a step in which the bonding target surface 11a and the bonding target surface 13a are bonded to form a bonding substrate having a bonding interface after the specific element introduction step.

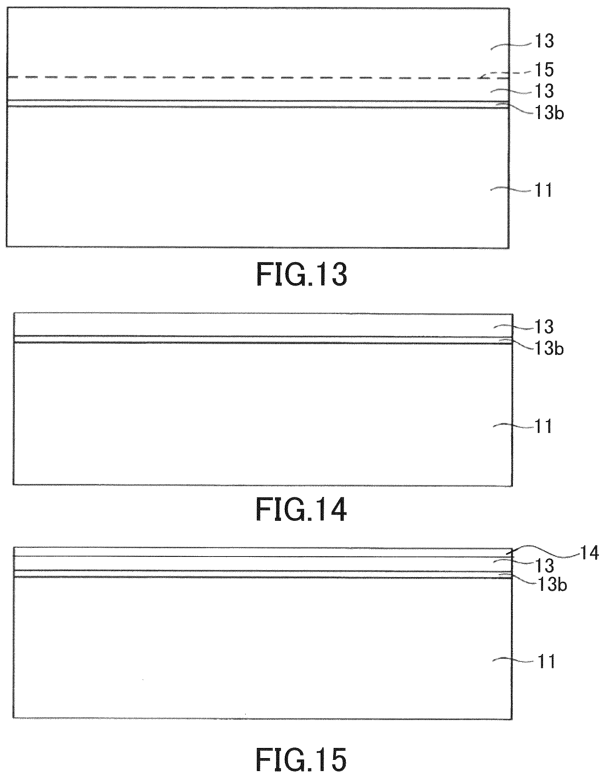

In FIG. 8, the bonding step is performed in step S3. In the bonding step, the bonding target surface 11a of the support substrate 11 and the bonding target surface 13a of the single crystal layer 13 are brought into contact with each other in a vacuum in the chamber 101. The bond present on the bonding target surface 11a which is active state, and the bond present on the bonding target surface 13a which is active state are bonded to each other, and the support substrate 11 and the single crystal layer 13 can be bonded. As a result, a structure in which the support substrate 11 and the single crystal layer 13 are bonded is formed, as shown in the schematic diagram of FIG. 13. The degree of vacuum may be, for example, about 1×10⁻⁴ to 1×10⁻⁶ Pa.

### <Peeling step (step S4)>

This step is a step in which a microbubble layer is formed in the hydrogen implantation layer 15 by applying heat during the peeling step after the bonding step and before the introduction step, and the single crystal layer 13 is peeled off at the microbubble layer as a peeling surface. That is, the single crystal layer 13 is peeled off at the hydrogen implantation layer 15 on which the microbubble layer is formed in the single crystal layer 13 as a peeling surface.

In FIG. 8, the peeling step is performed in step S4. Specifically, the support substrate 11 and the single crystal layer 13 bonded to each other are heated to about 800°C or higher. The atmosphere for the peeling may be at least one of an inert gas such as argon (Ar) or nitrogen (N) or a vacuum. The degree of vacuum may be, for example, about 1×10⁻⁴ to 1 ×10⁻⁶ Pa. The peeling may be performed using rapid thermal annealing (RTA) or a furnace. This allows the single crystal layer 13 to be separated at the hydrogen implantation layer 15. As a result, as shown in the schematic diagram of FIG. 14, a structure can be formed in which the single crystal layer 13 having a thickness of, for example, 0.5 µm is bonded to the support substrate 11 via a doping layer 13b.

### <Introduction step (step S5)>

This step is a step of introducing vacancy and interstitial atom into at least one of the first semiconductor layer or the second semiconductor layer of a semiconductor substrate including a first semiconductor layer and a second semiconductor layer in contact with the first semiconductor layer. For example, the vacancy and interstitial atom are introduced into the single crystal layer 13 or the support substrate 11 after the peeling step.

In FIG. 8, in step S5, a step of introducing vacancy and interstitial atom is performed. As a method for introducing vacancy and interstitial atom, at least one of ion implantation, neutral element implantation, plasma irradiation, and sputtering can be used. When argon (Ar) is used to introduce the vacancy and the interstitial atom, argon (Ar) is introduced into the bonding target surface 13a of the single crystal layer 13 by ion implantation. As a result, as shown in the schematic diagram of FIG. 15, a region 14 containing many vacancies and interstitial atoms is formed in the single crystal layer 13.

The vacancy and interstitial atom may be introduced only into the single crystal layer 13, only into the support substrate 11, or into both the single crystal layer 13 and the support substrate 11.

The step of introducing vacancy and interstitial atom is performed between the peeling step and the heat treatment step.

### <Heat treatment step (step S6)>

This step is a step in which the semiconductor substrate is heat treated after the introduction step to form the sessile dislocation with a density of 1E13/cm³ to 1E18/cm³ in the layer into which vacancy and interstitial atom have been introduced.

In FIG. 8, a heat treatment step is performed in step S6. In the heat treatment step, the support substrate 11, the doping layer 13b, and the single crystal layer 13 are heat-treated. The heat treatment temperature is preferably a temperature at which the introduced phosphorus is activated, and may be heated to 1100°C to 2200°C, more preferably 1200°C to 2100°C, depending on the material used for the semiconductor. If the heat treatment temperature is less than 1100°C, it may be difficult to form the sessile dislocation. If the heat treatment temperature is higher than 2200°C, the semiconductor material such as SiC may sublimate, causing surface roughness of the bonded substrate. For example, if the support substrate 11 is polycrystalline SiC and the single crystal layer 13 is a single crystal layer of 4H-SiC, the heat treatment temperature is preferably 1200°C to 2100°C, more preferably 1600°C to 1800°C, more specifically, about 1700°C.

The atmosphere of the heat treatment may be at least one of an inert gas such as argon (Ar) or nitrogen (N), or a vacuum. The degree of vacuum may be, for example, about 1×10⁻⁴ to 1×10⁻⁶ Pa. The heat treatment step may be performed in the furnace in which the peeling step was performed. Also, as long as the heat treatment time is 1 minute or more, the sessile dislocation can be formed without any problems. The upper limit of the heat treatment time is not particularly limited, but may be, for example, 100 hours in consideration of manufacturing efficiency. For example, the heat treatment time can be set between 1 minute and 10 hours.

### <Formation of sessile dislocation>

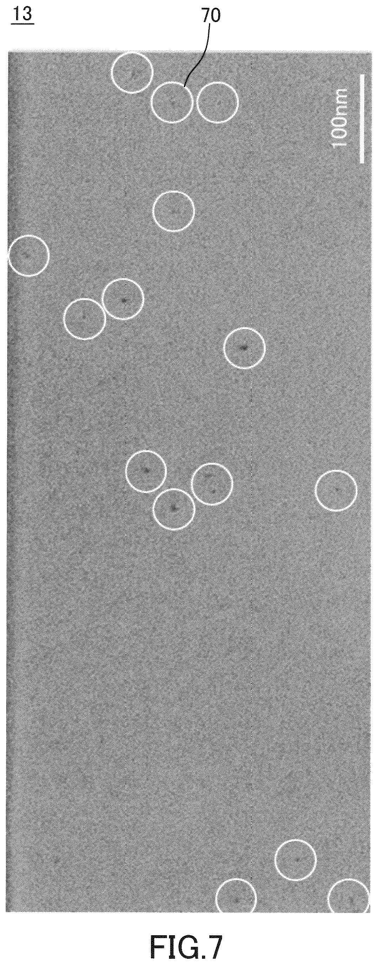

Figures 6 and 7 show TEM observation images of the cross section of the single crystal layer 13 after the heat treatment step at 1100°C and 1700°C, respectively, in the case of a bonded substrate in which the support substrate 11 is polycrystalline SiC and the single crystal layer 13 is a single crystal layer of 4H-SiC. When the heat treatment temperature in the heat treatment step is 1100°C (FIG. 6), no sessile dislocation is found in the single crystal layer 13, but when the heat treatment temperature is 1700°C (FIG. 7), the sessile dislocation 40 is found in the multiple regions 70 surrounded by white circles in the single crystal layer 13, and it is understood that heat treatment is necessary to form the sessile dislocation. That is, the vacancy and interstitial atom introduced into the single crystal SiC layer in the vacancy and interstitial atom introduction step gather together by appropriate heat treatment to form the sessile dislocation.

### <Effect of sessile dislocation>

By forming a device on a bonded substrate in which the sessile dislocation is formed, even if metal contamination occurs, the metal is gettered by the sessile dislocation, so that it is possible to suppress the decrease in device yield and reliability due to poor gate insulating film breakdown voltage and leakage current generation.

In the method for manufacturing a semiconductor substrate of the present invention, the introduction step and the heat treatment step are essential steps, and the other steps are optional. For example, the bonded substrate may be manufactured by carrying out the steps S0 to S4, or a bonded substrate manufactured by carrying out the steps S0 to S4 may be obtained by purchasing, etc., and the introduction step and the heat treatment step may be carried out.

### <Modifications>

The above describes in detail an example of an embodiment of the present invention, but these are merely examples and do not limit the scope of the present invention. For example, as described below, the present invention includes various modifications and changes to the specific examples exemplified above.

The element used when introducing the vacancy and the interstitial atom may be silicon (Si) instead of argon. In this case, the composition ratio of the region into which Si is introduced is such that the proportion of silicon is greater than that of carbon. In this case, it can be said that this region is composed of silicon-rich SiC. For example, the composition ratio of silicon is in the range of 50 to 60 atomic %. In this region, silicon is present at a very high concentration, so that the crystal structure of SiC cannot be maintained, and the crystal structure changes from SiC. In other words, a region of a composite material containing carbon and silicon is formed, and this region contains a very large number of the vacancies and the interstitial atoms.

The element used to introduce the vacancy and the interstitial atom may be carbon (C). In this case, the composition ratio of the region where C is introduced is higher in carbon than in silicon. In this case, it can be said that the interface is composed of carbon-rich SiC. For example, the composition ratio of carbon is in the range of 50 to 60 atomic %. In this case, as described above, the crystal structure changes from SiC. That is, a region of a composite material containing carbon and silicon is formed, and this region contains a large number of the vacancies and the interstitial atoms.

The element used to introduce the vacancy and the interstitial atom may be an element that is difficult to become a carrier and has a high effect of forming the vacancy and the interstitial atom. For example, it may be at least one of rare gases such as helium (He), neon (Ne), argon (Ar), and xenon (Xe), and hydrogen (H).

The element used to introduce the vacancy and the interstitial atom may be an element that easily becomes a carrier and has a high effect of forming the vacancy and the interstitial atom. For example, it may be at least one of nitrogen (N), phosphorus (P), boron (B), and aluminum (Al).

In addition, in the step of introducing the vacancy and the interstitial atom, a method of irradiating a neutral element such as a FAB gun or an ionized element such as an ion gun may be used. For example, the bonded substrate 10 is set in a vacuum chamber, and a neutral atomic beam or an ion beam of argon is irradiated onto the surface of the single crystal layer 13. One example of the irradiation conditions is irradiation with argon (Ar) for 10 sec with an incident energy of 1.8 keV.

In addition, in the irradiation step (step S2), ions of a specific element may be irradiated, and ions such as nitrogen or phosphorus may be further irradiated. In the irradiation step, it is preferable to irradiate with nitrogen. This allows the step of activating the surfaces of the support substrate 11 and the single crystal layer 13 to function as a step of introducing nitrogen, phosphorus, or the like into the support substrate 11 and the single crystal layer 13. Therefore, the step of introducing the specific element (step S1) can be omitted, making it possible to reduce the number of steps in the manufacturing method of the semiconductor substrate.

In the step of introducing the specific element and the step of introducing the vacancy and the interstitial atom, ions may be implanted through a mask material. The mask material may be at least one of a silicon oxide film, a silicon nitride film, and a resist.

The characteristic element that generates carriers in the support substrate 11 and the single crystal layer 13 is not limited to being introduced by the step of introducing the characteristic element. The step of introducing the characteristic element may be omitted by using the support substrate 11 and the single crystal layer 13 in which the characteristic element has been introduced beforehand. In this embodiment, an n-type support substrate as the support substrate 11 doped with nitrogen, phosphorus, or the like at a high concentration, and a single crystal layer 13 doped with nitrogen, phosphorus, or the like at a high concentration may be used. The concentration of the characteristic element doped in advance into the substrate may be equal to or higher than the concentration of the characteristic element at the bonded interface, which is introduced in the step of introducing the characteristic element. In this embodiment, an n-type support substrate as the support substrate 11 doped with nitrogen or phosphorus at 1×10¹⁹/cm³ or more, or single crystal layer 13 doped with nitrogen or phosphorus at 1×10¹⁹/cm³ or more may be used.

The method used in the step of introducing the specific element (step S1) may be an ion implantation method, a neutral element implantation method, or a plasma doping method, but a thermal diffusion method may also be used. The thermal diffusion method has a principle of causing a specific element such as phosphorus to exist in high concentration around the support substrate 11 or the single crystal layer 13, and then heating the bonded substrate 10. Therefore, the thermal diffusion method can maximize the concentration of the specific element such as phosphorus on the surface of the support substrate 11 or the single crystal layer 13. In addition, the thermal diffusion method can narrow the width of the concentration profile of the specific element compared to the case of using the ion implantation method. This makes it possible to form a concentration profile of the specific element having a width corresponding to the width (about several nanometers) of the potential barrier that can be passed through by the tunnel effect. In addition, when the semiconductor material into which the specific element is introduced is SiC, since the thermal diffusion coefficient of impurities in SiC is very small, it is preferable to carry out thermal diffusion at a high temperature of about 1100°C or more. This allows diffusion to be carried out with a width corresponding to the width of the potential barrier of about several nanometers that can produce a tunnel effect.

The order of the specific element introduction step (step S1) and the hydrogen ion implantation step (step S0) may be interchanged. For example, it is possible to first introduce phosphorus as the specific element into the single crystal layer 13, and then ion-implant hydrogen into the single crystal layer 13.

After the heat treatment step (step S6), a single crystal layer of a required thickness may be epitaxially grown on the single crystal layer 13. This epitaxial layer becomes the formation region of various elements described below. The thickness of the epitaxial layer required for the formation of various elements is generally 5 µm or more in the case of SiC, and may be about 5 µm to 30 µm.

At least one of the semiconductor element and the semiconductor device may be formed on the epitaxial layer.

Examples of the semiconductor element include a rectifier element (such as a Schottky diode or a PN diode), a bipolar transistor, a unipolar transistor, a field effect transistor (such as a MOSFET), an IGBT, a thermistor, a varistor, a thyristor, a light emitting element (such as a light emitting diode or a laser diode), a light receiving element, and a photoelectric conversion element.

Examples of the semiconductor device include a logic circuit, an arithmetic circuit, an optical waveguide, an optical amplifier, an analog IC, a power supply IC, an integrated circuit, a linear circuit (linear IC), a counting circuit (digital IC), a microcomputer, a display driver, a semi-custom, an FPGA, a memory (such as a DRAM, SRAM, or flash memory), a sensor, a MEMS, a power device, a high frequency device, an optical device, and a hybrid integrated circuit (hybrid IC).

When SiC is used for the single crystal layer 13, it is not limited to a single crystal of 4H-SiC. Various polytypes of single crystal SiC, such as 3C-SiC and 6H-SiC, can be used as the single crystal layer 13. In addition, when polycrystalline SiC is used for the support substrate 11, it is not limited to polycrystalline 3C-SiC, and various polytypes of polycrystalline SiC can be used.

### Examples

The present invention will be described in more detail below, but the present invention is not limited to the following examples.

### (Evaluation of metal gettering effect)

As an example, the bonded substrate 10 having the single crystal layer 13 of about 0.4 µm made of single crystal 4H-SiC containing Ti on the support substrate 11 made of polycrystalline SiC was used to evaluate the metal gettering effect by the sessile dislocation. In the introduction step, vacancy and interstitial atom were introduced into this single crystal SiC layer 13 by ion implantation of hydrogen, and the bonded substrate was heat-treated at 1700°C in the heat treatment step to form the sessile dislocation of about 8E14/cm³ in the single crystal layer 13, as shown in FIG. 5. On the single crystal layer 13 of this bonded substrate 10, the SiC epitaxial layer 15 of about 10 µm was grown at a temperature condition of 1630°C, and a SIMS analysis of the Ti concentration distribution was performed to evaluate whether the Ti gettered by the sessile dislocation remained in a captured state without diffusing, thereby investigating the gettering effect due to the sessile dislocation.

As a reference example for evaluating the gettering effect of metals due to the sessile dislocation, a single crystal SiC substrate 80 without the sessile dislocation was epitaxially grown of about 10 µm at a temperature condition of 1630°C in the same manner as above, and a SIMS analysis of the Ti concentration distribution was performed to investigate the gettering effect in the same manner as in the example.

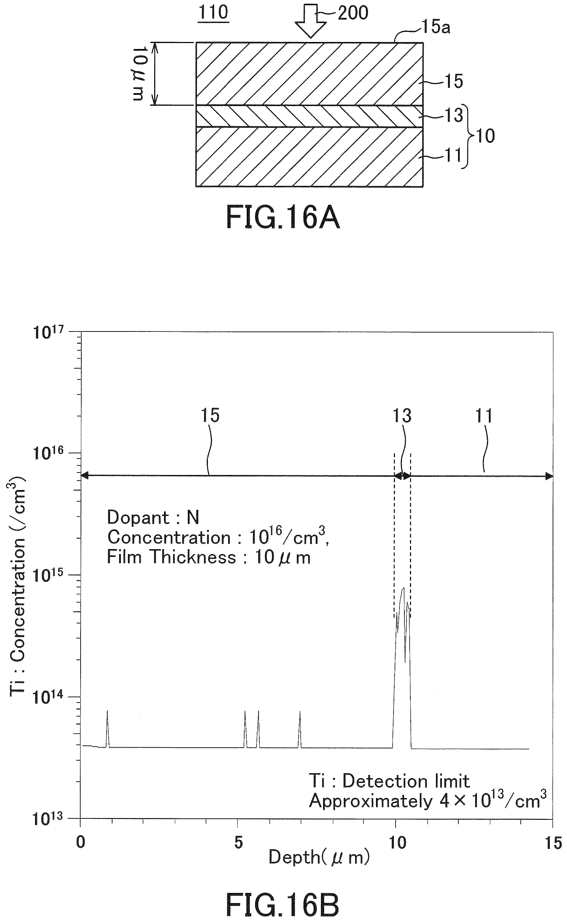

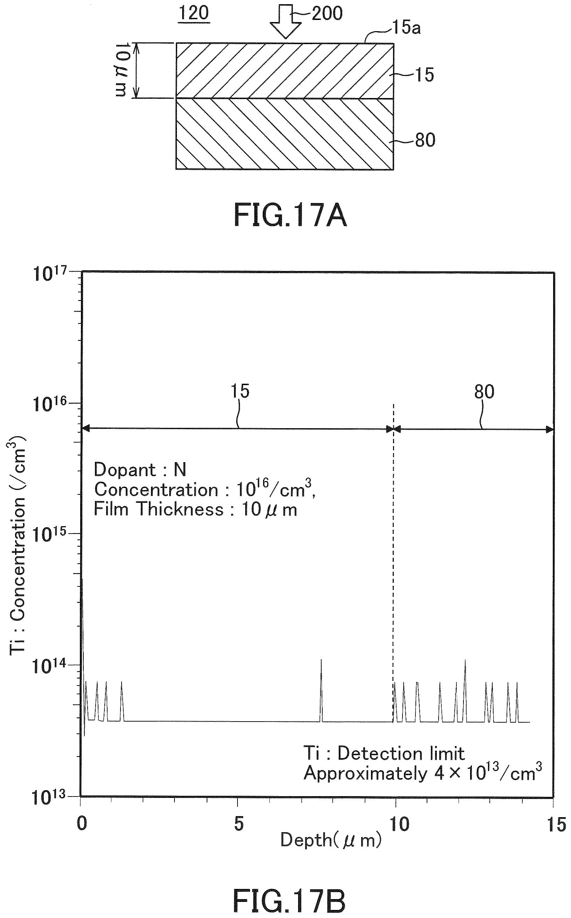

FIG. 16A shows a schematic diagram of a cross-sectional structure of a substrate 110 in which a SiC epitaxial layer 15 is grown on a single crystal layer 13 of a bonded substrate 10 as a substrate of an embodiment used in the SIMS analysis. FIG. 16B shows the result of the SIMS analysis of the substrate 110. In the SIMS analysis, ions were injected into the surface 15a of the SiC epitaxial layer 15 as shown by the arrow 200 in FIG. 16A to evaluate the distribution of the ion-implanted element (Ti) in the depth direction of the substrate 110. Also, FIG. 17A shows a schematic diagram of a cross-sectional structure of a substrate 120 in which a SiC epitaxial layer 15 is grown on a single crystal SiC substrate 80 as a substrate of a reference embodiment used in the SIMS analysis. FIG. 17B shows the result of the SIMS analysis of the substrate 120. In the SIMS analysis of the reference example, ions were injected into the surface 15a of the SiC epitaxial layer 15 as shown by the arrow 200 in FIG. 17A, as in the example, to evaluate the distribution of the ion-implanted element (Ti) in the depth direction of the substrate 120.

The SIMS device used in this analysis was an IMS-7f manufactured by CAMECA, and the analysis conditions were a primary ion species of O²⁺, a primary acceleration voltage of 11.0 kV, and a detection area of 30 µmΦ. In FIG. 16B, the surface 15a of the SiC epitaxial layer 15 of the substrate 110 was at a depth of 0 µm, the interface position between the SiC epitaxial layer 15 and the single crystal layer 13 of SiC was at a depth of about 10 µm from the surface 15a, and the interface position between the single crystal layer 13 of SiC and the support substrate 11 made of polycrystalline SiC was at a depth of about 10.4 µm from the surface 15a. In FIG. 17B, the surface 15a of the SiC epitaxial layer 15 of the substrate 120 is at a depth of 0 µm, and the interface between the SiC epitaxial layer 15 and the single crystal SiC substrate 80 is at a depth of about 10 µm from the surface 15a.

The results in FIG. 16B show that even after the SiC epitaxial layer 15 is grown at a temperature condition of 1630°C, Ti of the order of 1E14/cm³ remains in the single crystal layer 13 of SiC where the sessile dislocation exists, and Ti does not diffuse into the SiC epitaxial layer. Since the SiC epitaxial layer 15 is a region where devices are formed, if metal does not diffuse into this region, device characteristics will not deteriorate due to metal contamination. In FIG. 16B, the four peaks in the epitaxial layer observed at depths of 1 µm and 5 to 7 µm are not Ti detection but noise. That is, Ti was not detected in the epitaxial layer, and Ti did not diffuse from the single crystal SiC layer to the epitaxial layer. This result shows that the sessile dislocation maintain the state in which the gettered Ti does not diffuse but rather captures it.

On the other hand, in FIG. 17B, the peaks observed in the SiC epitaxial layer 15 and the single crystal SiC substrate 80 are all noise, and Ti was not detected. That is, since there is no sessile dislocation below the SiC epitaxial layer 15, the result shows that Ti is not gettered, and Ti is diffused and does not exist in either the SiC epitaxial layer 15 or the single crystal SiC substrate 80. Therefore, in the absence of the sessile dislocation, if the metal contamination level increases, the risk of device characteristic degradation increases.

### (Summary)

As described above, the present invention can provide a semiconductor substrate having the sessile dislocation that act as metal gettering and do not cause defects to extend, in at least one of the semiconductor layers of a semiconductor substrate formed by bonding semiconductor layers, and a method for manufacturing the semiconductor substrate, therefore, the present invention is industrially useful.

### Reference Signs List

10: bonded substrate, 11: supporting substrate, 11a: bonding target surface, 12: bonding interface, 13: single crystal layer, 13a: bonding target surface, 13b: doping layer, 14: region with many vacancies and interstitial atoms, 15: SiC epitaxial layer, 30: bonded SiC substrate, 31: polycrystalline SiC substrate, 33: single crystal SiC layer, 35: bonded interface, 40: sessile dislocation, 41: stacking fault, 42: dislocation loop, 50: region, 60: region, 70: region, 80: single crystal SiC substrate, 101: chamber, 102: FAB gun, 103: neutral element beam, 110: substrate, 120: substrate

## Claims

1. A semiconductor substrate comprising a first semiconductor layer and a second semiconductor layer in contact with the first semiconductor layer,
wherein at least one of the first semiconductor layer and the second semiconductor layer has a sessile dislocation composed of a stacking fault and a dislocation loop surrounding the stacking fault,
and the density of the sessile dislocation is 1E13/cm³ to 1E18/cm³.

2. The semiconductor substrate according to claim 1, wherein the first semiconductor layer and the second semiconductor layer are any of silicon carbide (SiC), silicon (Si), carbon (C), gallium nitride (GaN), aluminum nitride (AIN), and gallium oxide (Ga₂O₃).

3. The semiconductor substrate according to claim 1 or 2, wherein the first semiconductor layer is a silicon carbide single crystal layer in which the sessile dislocation is present, and the second semiconductor layer is a silicon carbide polycrystalline layer.

4. The semiconductor substrate according to claim 1 or 2, further comprising an epitaxial layer in contact with the first semiconductor layer.

5. The semiconductor substrate according to claim 4, further comprising at least one of a semiconductor element and a semiconductor device in contact with the epitaxial layer.

6. A method for manufacturing a semiconductor substrate, comprising:
an introduction step of introducing a vacancy and an interstitial atom into at least one of a first semiconductor layer and a second semiconductor layer in contact with the first semiconductor layer of the semiconductor substrate, and
a heat treatment step of heat-treating the semiconductor substrate after the introduction step to form a sessile dislocation having a density of 1E13/cm³ to 1E18/cm³ in the layer into which the vacancy and the interstitial atom have been introduced.

7. The method for manufacturing a semiconductor substrate according to claim 6, wherein the introduction step is a step of introducing the vacancy and the interstitial atom by at least one of ion implantation, neutral element implantation, plasma irradiation, and sputtering.
